(19) Europäisches Patentamt
European Patent Office
Office européen des brevets

(11) **EP 2 571 048 B1**

(12) **FASCICULE DE BREVET EUROPEEN**

(45) Date de publication et mention
de la délivrance du brevet:
**10.08.2016 Bulletin 2016/32**

(51) Int Cl.:
***H01L 23/053*** *(2006.01)*    ***H01L 23/31*** *(2006.01)*
***B81C 1/00*** *(2006.01)*    ***B81B 7/00*** *(2006.01)*
***B29C 41/20*** *(2006.01)*

(21) Numéro de dépôt: **12182855.2**

(22) Date de dépôt: **03.09.2012**

(54) **Procédé de réalisation d'une structure à cavité fermée hermétiquement et sous atmosphère contrôlée**

Verfahren zur Herstellung einer Struktur mit einem hermetisch und unter kontrolliertem Unterdruck verschlossenem Hohlraum

Method for producing a structure with a cavity sealed hermetically under a controlled atmosphere

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.09.2011 FR 1157975**

(43) Date de publication de la demande:
**20.03.2013 Bulletin 2013/12**

(73) Titulaire: **Commissariat à l'Énergie Atomique et aux Énergies Alternatives 75015 Paris (FR)**

(72) Inventeurs:
• **Pornin, Jean-Louis**
  **38920 CROLLES (FR)**

• **Baillin, Xavier**
  **38920 CROLLES (FR)**
• **Gillot, Charlotte**
  **38120 SAINT EGREVE (FR)**
• **Vandroux, Laurent**
  **38570 LE CHEYLAS (FR)**

(74) Mandataire: **Ilgart, Jean-Christophe et al BREVALEX 95, rue d'Amsterdam 75378 Paris Cedex 8 (FR)**

(56) Documents cités:
**WO-A2-2005/089348     DE-A1-102007 022 509
US-A1- 2003 183 916     US-A1- 2011 048 129**

EP 2 571 048 B1

**Description**

**DOMAINE TECHNIQUE**

L'invention concerne un procédé de réalisation d'une structure d'encapsulation comportant une cavité fermée hermétiquement et dont l'atmosphère est contrôlée. L'invention s'applique avantageusement pour réaliser une encapsulation de dispositifs électroniques tels que des dispositifs de type MEMS (microsystème électromécanique), MOEMS (microsystème opto-électromécanique) ou NEMS (nanosystème électromécanique), par exemple des commutateurs, qui fonctionnent dans des environnements où la pression est comprise entre environ une ou plusieurs centaines de mbar (jusqu'à environ 1 bar), afin par exemple d'amortir les vibrations des dispositifs, ou des composants passifs tels que des capacités variables ou ajustables.

**ÉTAT DE LA TECHNIQUE ANTÉRIEURE**

Pour encapsuler un dispositif électronique, par exemple de type MEMS, dans une cavité, il est connu de réaliser le dispositif électronique sur un premier substrat, puis de solidariser un second substrat au premier substrat par l'intermédiaire d'une interface de collage. Le dispositif se retrouve alors encapsulé dans la cavité qui est délimitée par les deux substrats formant les parois supérieures et inférieures de la cavité, et par l'interface de collage qui forme les parois latérales de la cavité.

Afin notamment de limiter l'encombrement de la structure d'encapsulation, il est également connu de réaliser une encapsulation de dispositifs électroniques par couches minces, appelée PCM (Packaging Couche Mince). Une encapsulation de type PCM consiste à réaliser tout d'abord le dispositif électronique sur un substrat, puis à recouvrir le dispositif électronique d'une couche sacrificielle mise en forme selon la forme de la cavité souhaitée. Cette couche sacrificielle est ensuite recouverte par une couche mince destinée à former un capot. Des trous de libération sont ensuite réalisés à travers le capot, formant ainsi des accès pour graver la couche sacrificielle. Les trous de libération sont ensuite bouchés. On obtient ainsi une cavité dans laquelle le dispositif électronique est encapsulé.

Pour fonctionner correctement, certains dispositifs électroniques, comme par exemple des dispositifs MEMS de type commutateur, doivent être disposés dans des atmosphères gazeuses contrôlées dans lesquelles règnent des pressions comprises entre environ 100 mbar et environ 1 bar. Cette atmosphère permet notamment d'amortir les vibrations de ces dispositifs, et donc d'assurer un fonctionnement correct de ces dispositifs.

Dans le cas d'une encapsulation de type PCM, les trous de libération peuvent être bouchés en réalisant un dépôt sous vide de type PVD (dépôt physique en phase vapeur) d'un matériau de bouchage. La pression obtenue dans la cavité correspond à la pression ambiante régnant dans l'enceinte de dépôt lors de la fermeture de la cavité. Toutefois, les pressions pouvant être obtenues avec une telle fermeture de la cavité, généralement de quelques mbar, sont insuffisantes pour assurer un fonctionnement correct de ces dispositifs.

La fermeture de la cavité peut également être réalisée par un dépôt de type PECVD (dépôt chimique en phase vapeur assisté par plasma) du matériau de bouchage. Là encore, les pressions pouvant être obtenues sont insuffisantes (au mieux quelques dizaines de mbar). De plus, une telle fermeture de la cavité génère souvent des résidus de gaz précurseurs dans la cavité, ces résidus pouvant être gênants pour le fonctionnement du dispositif.

Il est également possible de fermer la cavité en réalisant un dépôt de polymère bouchant les trous de libération. Mais dans ce cas, la présence de composés organiques au niveau des trous de libération peut être gênante pour le fonctionnement du dispositif électronique. De plus, l'herméticité de la cavité ainsi fermée est généralement mauvaise.

Pour obtenir des pressions de l'ordre de quelques centaines de mbar, le document EP 0 846 941 A1 propose un procédé d'implantation d'une phase gazeuse au travers d'une membrane formant le capot d'une cavité. Cette implantation gazeuse est réalisée après la fermeture de la cavité. Bien que ce procédé permette d'obtenir au sein de la cavité la phase gazeuse souhaitée à la pression désirée, les énergies nécessaires pour faire passer la phase gazeuse au travers de la membrane et des couches de fermeture sont très importantes. De plus, certains dispositifs électroniques peuvent être sensibles à cette implantation gazeuse. Or, il est difficile de protéger ces dispositifs lors d'une telle implantation gazeuse.

Le document DE 10 2007 022509 A1 propose un procédé de réalisation d'une structure d'encapsulation dans lequel un gaz est produit par la décomposition d'un polymère chauffé.

**EXPOSÉ DE L'INVENTION**

Un but de la présente invention est de proposer un procédé de réalisation d'une structure d'encapsulation à cavité fermée hermétiquement permettant d'obtenir, au sein de la cavité, une pression par exemple supérieure ou égale à environ 100 mbar, qui soit compatible avec une encapsulation de type PCM, et cela sans avoir à réaliser d'implantation gazeuse dans la cavité après la fermeture de celle-ci.

Pour cela, la présente invention propose un procédé de réalisation d'une structure d'encapsulation comportant au moins les étapes de :

- réalisation d'au moins une portion de matériau apte à libérer au moins un gaz lorsque ledit matériau est chauffé, la portion de matériau communiquant avec l'intérieur d'une cavité fermée hermétiquement de la structure d'encapsulation,
- chauffage de tout ou partie de ladite portion de matériau tel qu'au moins une partie du gaz soit libérée depuis ladite portion de matériau dans la cavité.

Ladite portion de matériau apte à libérer au moins un gaz lorsque ledit matériau est chauffé comporte des éléments piégés dans ladite portion de matériau, lesdits éléments piégés se libérant de ladite portion de matériau sous forme gazeuse lors du chauffage dudit matériau.

Le procédé selon l'invention consiste donc à former dans la cavité, ou à un endroit en relation avec l'intérieure de la cavité, avant ou pendant sa fermeture hermétique, un dépôt de matériau, par exemple sous forme de couche(s) et/ou de portion(s), apte à libérer au moins un gaz, puis à libérer ledit gaz après la fermeture hermétique de la cavité, en chauffant ledit matériau.

Un tel procédé permet donc de libérer au moins un gaz après la fermeture hermétique de la cavité, ce gaz augmentant la pression régnant dans la cavité, ce qui permet d'obtenir une pression finale dans la cavité fermée hermétiquement qui est supérieure à la pression régnant dans la cavité lors de sa fermeture, tout en évitant d'avoir à réaliser une implantation gazeuse dans la cavité après sa fermeture.

De plus, ce procédé permet de contrôler, via les paramètres de chauffe et/ou la quantité de gaz potentiellement libérable depuis le matériau, la quantité de gaz qui est libéré dans la cavité, et donc de contrôler précisément la pression finale obtenue au sein de la cavité fermée hermétiquement. De plus, ce procédé permet de contrôler également la nature du gaz libéré dans la cavité, et donc le type d'atmosphère gazeuse régnant dans la cavité après sa fermeture.

Selon la pression souhaitée au sein de la cavité, il est possible de choisir le volume de la ou des portions de matériau formées dans la cavité, ce qui modifie d'autant le volume de la cavité et donc le volume de gaz à libérer pour obtenir la pression souhaitée. La ou les portions de matériau peuvent être dimensionnées en fonction de la quantité de gaz à libérer dans la cavité.

De plus, contrairement à des gaz issus de la décomposition de matériaux par exemple organiques, la nature des éléments piégés, c'est-à-dire enfermés ou stockés, dans le matériau peuvent être choisis sans être limités par la nature du matériau destiné à réaliser la libération du gaz. Les gaz issus d'une décomposition d'un matériau organique correspondent à des gaz organiques qui peuvent être agressifs ou perturbants pour des éléments présents dans la structure d'encapsulation, notamment vis-à-vis de contacts électriques. Dans le procédé selon l'invention, la portion de matériau dont sont issus le ou les gaz libérés n'est pas décomposée car ce ou ces gaz sont issus des éléments piégés dans le matériau, et non du matériau en lui-même. Les gaz libérés peuvent avantageusement être non organiques.

Les éléments piégés peuvent être des dopants implantés et/ou des éléments chimiques issus par exemple des procédés de réalisation de ladite portion de matériau ou d'étapes mises en oeuvre en présence de ladite portion de matériau, ces procédés ou étapes pouvant être mis en oeuvre de façon à optimiser le volume de ces éléments piégés dans le matériau, et donc optimiser le volume de gaz apte à être libéré du matériau. Les éléments chimiques piégés peuvent être des éléments issus de gaz plasma utilisés lors de la réalisation de ladite portion (par exemple de l'azote, et/ou de l'hydrogène présent lors d'un dépôt électrolytique, et/ou de l'argon présent lors d'une gravure, etc.). Les éléments piégés peuvent avantageusement être non organiques.

Enfin, ce procédé est compatible avec une encapsulation de type PCM, mais également une encapsulation par report de substrat.

La portion de matériau réalisée communique avec l'intérieur de la cavité fermée, ce qui signifie qu'un fluide peut circuler depuis la portion de matériau jusqu'à l'intérieur de la cavité.

Le procédé peut comporter en outre, avant une fermeture hermétique de la cavité, une étape de réalisation d'au moins un dispositif électronique dans la cavité. Un tel procédé permet de contrôler la nature du ou des gaz destinés à être libérés dans la cavité, ce ou ces gaz pouvant être choisis parmi des gaz inactifs ou sans incidence sur les performances ou le fonctionnement du dispositif électronique.

Le terme « dispositif électronique » désigne tout type de dispositif électronique et/ou électrique, dont les dimensions peuvent être micrométriques (dispositif microélectronique), mais également nanométriques (dispositif nanoélectronique) ou encore millimétriques.

Le procédé peut comporter en outre, avant la mise en oeuvre de l'étape de chauffage de ladite portion de matériau, les étapes de :

- réalisation du dispositif électronique et de ladite portion de matériau sur un substrat,
- réalisation de la cavité fermée hermétiquement dans laquelle peuvent être disposés au moins le dispositif électronique et ladite portion de matériau, la cavité pouvant être formée entre le substrat et un capot.

Le dispositif électronique peut être réalisé sur le substrat avant ou après ladite portion de matériau.

Dans ce cas, le procédé peut comporter en outre, lors de la réalisation de la cavité fermée hermétiquement, la réalisation d'au moins une couche de matériau apte à libérer au moins un gaz lorsque ledit matériau est chauffé, disposée dans la cavité et contre le capot, ou formant le capot, l'étape de chauffage pouvant réaliser également le chauffage de ladite couche de matériau, pouvant libérer au moins une partie du gaz depuis ladite couche de matériau dans la cavité.

La couche de matériau apte à libérer du gaz peut être une couche continue ou non, et peut comporter un ou plusieurs motifs dudit matériau.

De plus, ledit matériau, réalisé sous la forme d'une couche ou d'une ou plusieurs portions, peut être composé d'un empilement d'un ou plusieurs matériaux suivant la nature et le volume du ou des gaz à libérer dans la cavité. Lorsque l'on dispose un matériau apte à libérer du gaz sur le substrat et un matériau apte libérer du gaz contre le capot (ou formant le capot), ces matériaux peuvent être de même nature ou non.

Le procédé peut comporter en outre, avant la mise en oeuvre de l'étape de chauffage de ladite portion de matériau, les étapes de :

- réalisation du dispositif électronique sur un substrat,
- réalisation de la cavité fermée hermétiquement dans laquelle peut être disposé au moins le dispositif électronique, la cavité pouvant être formée entre le substrat et un capot, ladite portion de matériau pouvant former une couche de matériau disposée dans la cavité et contre le capot.

La réalisation de la cavité peut comporter la réalisation d'au moins un trou à travers au moins le capot tel que le trou puisse former un accès à l'intérieur de la cavité, la cavité pouvant être ensuite fermée hermétiquement en bouchant le trou par au moins une deuxième portion de matériau apte à libérer au moins un gaz lorsque ledit matériau est chauffé, l'étape de chauffage pouvant réaliser également le chauffage de ladite deuxième portion de matériau, libérant au moins une partie du gaz depuis ladite deuxième portion de matériau dans la cavité.

La réalisation de la cavité peut comporter la réalisation d'au moins un trou à travers au moins le capot tel que le trou puisse former un accès à l'intérieur de la cavité, la cavité pouvant être ensuite fermée hermétiquement en bouchant le trou par au moins une couche de matériau apte à libérer au moins un gaz lorsque ledit matériau est chauffé et recouvrant le capot, l'étape de chauffage pouvant réaliser également le chauffage de ladite couche de matériau, libérant au moins une partie du gaz depuis ladite couche de matériau dans la cavité.

Le procédé peut comporter en outre, avant la mise en oeuvre de l'étape de réalisation de ladite portion de matériau, les étapes de :

- réalisation du dispositif électronique sur un substrat,
- réalisation de la cavité dans laquelle peut être disposé au moins le dispositif électronique, la cavité pouvant être formée entre le substrat et un capot,

la réalisation de la cavité pouvant comporter la réalisation d'au moins un trou à travers au moins le capot, la cavité pouvant être ensuite fermée hermétiquement en réalisant ladite portion de matériau telle qu'elle puisse boucher le trou.

Le procédé peut comporter en outre, avant la mise en oeuvre de l'étape de réalisation de ladite portion de matériau, les étapes de :

- réalisation du dispositif électronique sur un substrat,
- réalisation de la cavité dans laquelle est disposé au moins le dispositif électronique, la cavité étant formée entre le substrat et un capot,

la réalisation de la cavité pouvant comporter la réalisation d'au moins un trou à travers au moins le capot, la cavité pouvant être ensuite fermée hermétiquement en réalisant ladite portion de matériau sous la forme d'une couche recouvrant le capot.

Au moins ladite portion de matériau peut être réalisée par au moins un dépôt de type PVD ou CVD (par exemple PECVD ou HDP-CVD) dudit matériau, ledit dépôt pouvant réaliser un stockage d'éléments gazeux dans ledit matériau.

Ledit matériau apte à libérer au moins un gaz lorsque ledit matériau est chauffé peut comporter des dopants implantés, lesdits dopants pouvant se libérer sous forme gazeuse lors du chauffage dudit matériau.

Le gaz libéré peut donc correspondre aux éléments gazeux stockées lors du dépôt de type PVD ou CVD ou aux dopants libérés sous forme gazeuse lors du chauffage. Il est également possible que le gaz libéré corresponde aux éléments gazeux stockées lors du dépôt de type PVD ou CVD et aux dopants libérés sous forme gazeuse lors du chauffage, ce qui permet de libérer plusieurs types de gaz.

Une fermeture hermétique de la cavité peut être réalisée sous vide ou sous pression réduite d'au moins un gaz. Ainsi, la pression finale et la nature du ou des gaz au sein de la cavité fermée hermétiquement dépendent complètement (cas d'une fermeture sous vide de la cavité) ou partiellement (cas d'une fermeture de la cavité sous pression d'un gaz) du ou des gaz libérés lors du chauffage du matériau. La présence d'air, d'humidité, ou de gaz précurseurs dans la cavité peut ainsi être évitée lors de la fermeture de la cavité.

Ledit matériau apte à libérer au moins un gaz lorsque ledit matériau est chauffé peut être composé d'au moins un métal, le chauffage de ladite portion de matériau pouvant être réalisé à une température supérieure ou égale à la température de fusion dudit matériau, ou encore à une température inférieure à la température de fusion dudit matériau.

Contrairement aux métaux généralement utilisés en microélectronique, qui sont recouverts d'un isolant, le matériau apte à libérer au moins un gaz peut correspondre à un métal déposé sur un isolant.

La réalisation de ladite portion de matériau apte à libérer au moins un gaz lorsque ledit matériau est chauffé peut comporter un premier dépôt de type PVD ou PECVD d'un premier métal et un deuxième dépôt par électrolyse ou électrolyse dégradée d'un deuxième métal sur le premier métal.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1A à 1E représentent les étapes d'un procédé de réalisation d'une structure d'encapsulation, objet de la présente invention, selon un premier mode de réalisation,
- la figure 2 représente une quantité de gaz libéré en mole par $mm^2$ d'un matériau chargé en espèces gazeuses en fonction de la température lors d'une étape de chauffage réalisée lors d'un procédé de réalisation d'une structure d'encapsulation, objet de la présente invention,
- la figure 3 représente une pression obtenue dans une cavité d'une structure d'encapsulation réalisée selon un procédé objet de la présente invention, en fonction du nombre de mole de gaz à l'intérieur de celle-ci,
- les figures 4 à 7 représentent des structures d'encapsulation obtenues par la mise en oeuvre de procédés de réalisation de structures d'encapsulation, objets de la présente invention, selon différents modes et variantes de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

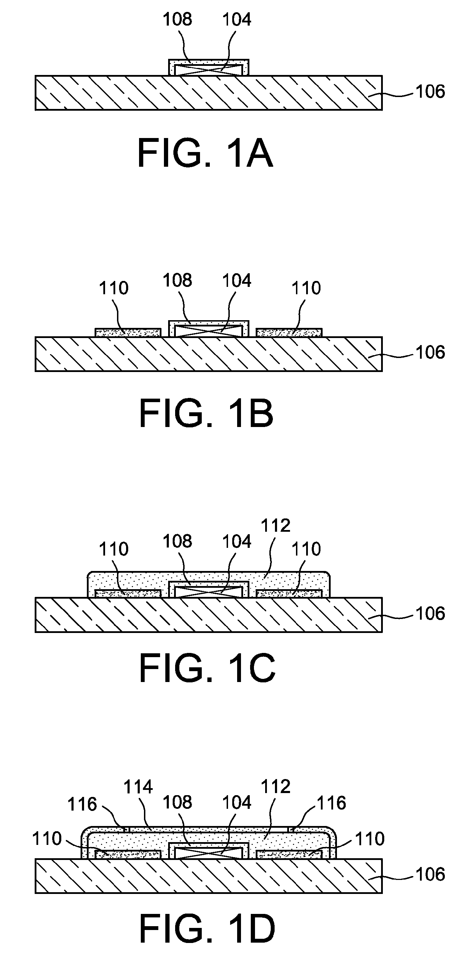

On se réfère tout d'abord aux figures 1A à 1E qui représentent les étapes d'un procédé de réalisation d'une structure d'encapsulation 100 selon un premier mode de réalisation, comportant une cavité 102 dans laquelle un dispositif électronique 104 est destiné à être encapsulé.

Comme représenté sur la figure 1A, on réalise sur un substrat 106, par exemple composé de silicium, un dispositif électronique 104, par exemple de type MEMS. Le dispositif électronique 104 est ici un commutateur MEMS destiné à fonctionner sous atmosphère et pression contrôlées. Le dispositif électronique 104 est formé de plusieurs éléments comportant des parties fixes et des parties mobiles. Lors de la réalisation du dispositif 104, les parties mobiles sont immobilisées par un matériau sacrificiel 108, par exemple composé de polymère et/ou de silicium polycristallin et apte à être gravé sélectivement par rapport aux autres matériaux qui seront présents dans la cavité 102, représenté schématiquement sur la figure 1A sous la forme d'une couche recouvrant le dispositif 104.

Des portions 110 de matériau chargé en éléments gazeux sont ensuite réalisées sur le substrat 106, autour du dispositif électronique 104 (figure 1B).

Pour cela, une couche de matériau dans lequel sont stockés des éléments gazeux est tout d'abord déposée, recouvrant le substrat 106 et le dispositif électronique 104 (et donc le matériau sacrificiel 108). Cette couche est ensuite mise en forme, par exemple par photolithographie et gravure, afin de conserver des portions 110 de ce matériau chargé en éléments gazeux sur le substrat 106, autour du dispositif électronique 104. Ces portions de matériau 110 sont localisées sur des surfaces du substrat 106 destinées à être encapsulées dans la future cavité 102. Les portions 110 peuvent être réalisées telles qu'elles occupent le plus de surface possible sur le substrat 106.

Le matériau des portions 110 dans lequel est enfermé le gaz est par exemple un matériau diélectrique tel que du $SiO_2$ ou du SiN. La présence de gaz dans ce matériau est obtenue grâce au procédé de dépôt mis en oeuvre. Ainsi, lorsque les portions 110 sont réalisées par un dépôt PVD du matériau, les gaz présents dans l'enceinte de dépôt sont piégés dans le matériau déposé grâce à la pression régnant dans l'enceinte de dépôt. Selon la nature du ou des gaz présents dans l'enceinte de dépôt, le matériau déposé peut donc être chargé d'un ou plusieurs types d'éléments gazeux selon la nature de l'atmosphère gazeuse souhaitée dans la future cavité 102, et sont par exemple de l'argon et/ou du dihydrogène et/ou du diazote. La pression et la nature du ou des gaz présents dans l'enceinte de dépôt sont par exemple choisies en fonction de la nature et de la quantité de gaz que l'on souhaite piéger, ou enfermer, dans le matériau des portions 110.

Dans une variante, le piégeage de gaz dans le matériau des portions 110 peut être obtenu en réalisant un dépôt PECVD de ce matériau. Par rapport à un dépôt PVD, un dépôt PECVD permet de piéger une plus grande quantité d'espèces gazeuses dans le matériau déposé. Toutefois, un tel dépôt PECVD piège également dans le matériau des espèces gazeuses plus complexes ainsi que des gaz précurseurs.

Dans une autre variante, d'autres types de procédés de dépôt ou d'étapes peuvent être mises en oeuvre pour réaliser un stockage d'éléments chimiques dans le matériau des portions 110.

On réalise ensuite une encapsulation par couche mince du dispositif électronique 104 et des portions de matériau 110. Ainsi, comme représenté sur la figure 1C, une couche de matériau sacrificiel 112, par exemple composée de polymère et/ou de silicium polycristallin, et par exemple de nature similaire au matériau sacrificiel 108, est ensuite déposée sur le substrat 106, en recouvrant le dispositif électronique 104 (et donc le matériau sacrificiel 108) et les portions 110 de matériau chargé en espèces gazeuses.

Cette couche de matériau sacrificiel 112 est mise en forme telle que le volume restant de cette couche 112 corresponde au volume souhaité de la future cavité 102. La couche 112 a par exemple une épaisseur comprise entre environ 1 $\mu$m et 10 $\mu$m, en fonction de la hauteur souhaitée de la future cavité 102. Le matériau sacrificiel est choisi tel qu'il puisse être gravé sélectivement par rapport aux autres matériaux destinés à être conservés dans la future cavité 102, c'est-à-dire le ou les matériaux du substrat 106, du dispositif électronique 104, des portions 110 ainsi que du futur capot.

On réalise ensuite un dépôt conforme d'un matériau formant une couche destinée à former le capot 114 de la cavité 102 dans laquelle le dispositif 104 et les portions de matériau 110 sont destinés à être encapsulés. Le capot 114 recouvre ainsi la couche sacrificielle 112. Ce capot 114 est par exemple composé d'un matériau diélectrique tel que du $SiO_2$ ou du SiN, mais peut également être composé d'un matériau semiconducteur tel que du silicium ou encore d'un matériau conducteur tel qu'un matériau métallique. L'épaisseur du capot 114 est par exemple comprise entre environ 0,1 $\mu$m et 5 $\mu$m.

On réalise ensuite à travers le capot 114, un ou plusieurs trous de libération 116, formant des accès à la couche sacrificielle 112 (voir la figure 1D, sur laquelle deux trous 116 sont représentés).

La couche sacrificielle 112 ainsi que le matériau sacrificiel 108 sont ensuite gravés à travers les trous de libération 116 par un ou plusieurs agents de gravure chimiques adaptés à la nature des matériaux à graver, formant ainsi la cavité 102 délimitée par le substrat 106 et le capot 114 et dans laquelle sont encapsulés le dispositif électronique 104 et les portions 110 de matériau chargé en espèces gazeuses.

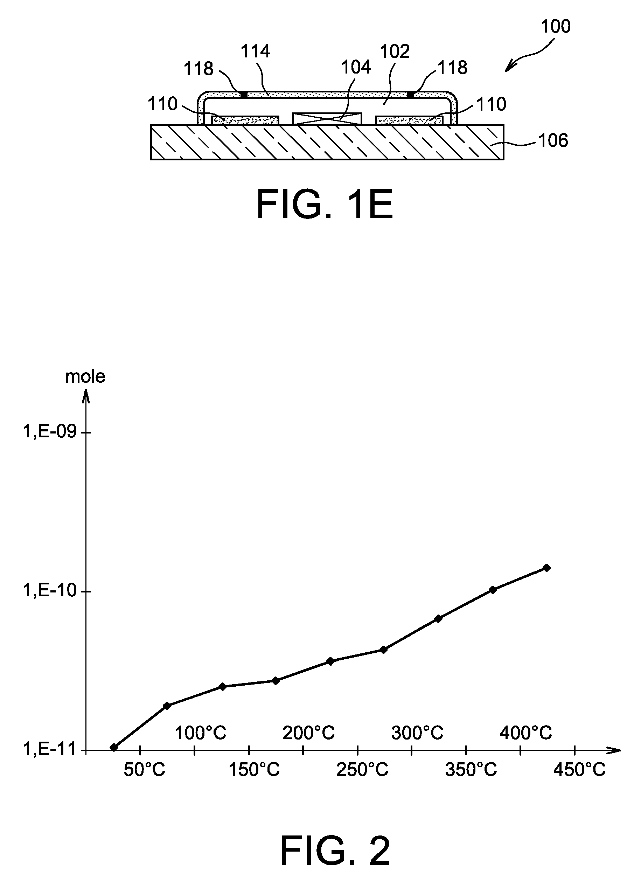

Les trous de libération 116 sont ensuite bouchés par un matériau de bouchage 118, correspondant par exemple à un matériau diélectrique ou métallique, obstruant les trous de libération 116 et fermant hermétiquement la cavité 102 (figure 1E).

La fermeture de la cavité 102 est avantageusement réalisée dans un environnement sous vide ou sous pression réduite d'un ou plusieurs gaz qui ne perturbent pas le fonctionnement du dispositif électronique 104, et cela afin d'éviter notamment la présence d'air, d'humidité et/ou de gaz précurseurs dans la cavité 102 fermée hermétiquement qui pourraient perturber le fonctionnement du dispositif électronique 104.

La structure d'encapsulation 100 est ensuite soumise à un cycle de chauffe afin de chauffer les portions 110, tel que les espèces gazeuses stockées dans les portions de matériau 110 s'échappent des portions 110 et soient libérées dans la cavité 102. Le chauffage des portions 110 est poursuivi jusqu'à ce que la pression régnant dans la cavité 102 atteigne la pression de fonctionnement souhaitée pour le dispositif électronique 104, par exemple comprise entre environ 100 mbar et 1 bar. La quantité de gaz libéré, qui est corrélée à la pression régnant dans la cavité 102, peut être ajustée par les paramètres du cycle thermique appliqué à la structure d'encapsulation 100, notamment la durée de chauffe et la température à laquelle sont exposées les portions de matériau 110.

La structure d'encapsulation 100 est par exemple chauffée à une température comprise entre environ 100°C et 400°C, ce qui rend ce procédé compatible avec la présence de dispositifs CMOS sur le substrat 106. Toutefois, si la structure d'encapsulation n'est pas en présence d'éléments limitant la température de chauffe, cette dernière peut être supérieure à 400°C. La durée du chauffage de la structure d'encapsulation 100 est par exemple comprise entre environ quelques minutes et quelques heures.

Dans ce premier mode de réalisation, les portions de matériau 110 chargées en espèces gazeuses sont réalisées après avoir réalisé le dispositif électronique 104, ce qui permet d'éviter d'éventuelles pertes d'espèces gazeuses ou contaminations des portions de matériau 110 par d'autres gaz pouvant survenir si ces portions 110 étaient réalisées sur le substrat 106 avant le dispositif électronique 104 et qu'elles étaient exposées aux étapes de mises en oeuvre du dispositif électronique 104 (étapes pouvant impliquer un budget thermique important). Toutefois, si les étapes mises en oeuvre pour réaliser le dispositif électronique 104 le permettent, c'est-à-dire ne dégradent pas le matériau chargé en espèces gazeuses, il est possible que les portions de matériau 110 soient réalisées sur le substrat 106 avant le dispositif électronique 104. Dans une autre variante, il est également possible que les portions de matériau 110 soient issues d'une ou plusieurs des couches de matériau utilisées pour former des parties du dispositif électronique 104.

Dans l'exemple précédemment décrit, le chauffage des portions 110 de matériau chargé en espèces gazeuses est réalisé en faisant subir à l'ensemble de la structure d'encapsulation 100 un cycle thermique. En variante, il est possible de chauffer localement la ou les portions 110 de matériau chargé en gaz, par exemple grâce à une excitation lumineuse des portions 110 par laser à travers le capot 114.

En fonction de la nature gazeuse et de la pression souhaitées dans la cavité 102, du cycle de température applicable et du rendement de dégazage des portions 110 pouvant être obtenu, il est possible d'adapter la quantité de gaz piégé dans le matériau des portions 110. La quantité de gaz dessorbé par une couche de matériau du type des portions 110 peut être caractérisée de la façon suivante :

On enferme sous vide, par exemple dans une ampoule, un échantillon de matériau de surface connue et dans lequel du gaz est piégé. On chauffe puis on refroidie l'échantillon de matériau afin de libérer les espèces gazeuses piégées. On mesure alors la pression dans l'ampoule, par exemple grâce à un dispositif de type vacuomètre à friction, ce qui permet de calculer la quantité de molécules déssorbées. La figure 2 représente le nombre cumulé de moles de gaz libérées par $mm^2$ de matériau, ici du tungstène, chargé en espèces gazeuses en fonction de la température de recuit.

En appliquant la formule PV = nRT, on peut calculer la pression équivalente à ce nombre de moles libérées dans une cavité de volume égal à $5.10^{-3}$ $mm^3$.

Par exemple, pour une quantité de $10^{-10}$ mole obtenue avec un cycle de chauffe à une température égale à environ 400°C, on obtient une pression égale à :

$$P = 10^{-10} \times 0,082 \times 300 / 5.10^{-9} = 0,5 \text{ atm}$$

avec n = $10^{-10}$ mole ;
R = 0,082 l.atm.K$^{-1}$.mole$^{-1}$ ;
T = 300 K ;
V = $5.10^{-9}$ l.

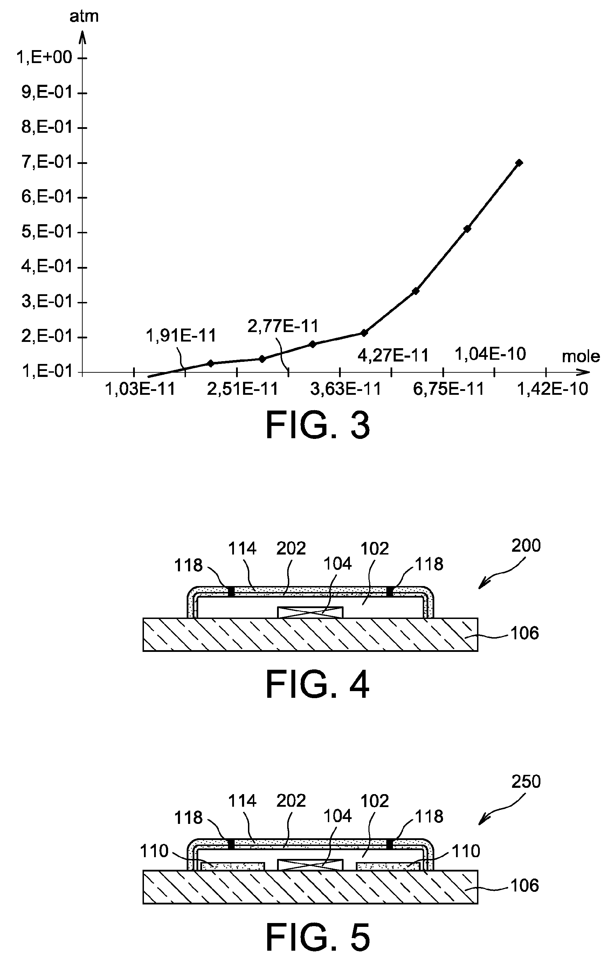

La figure 3 représente la pression obtenue dans cette cavité en fonction du nombre de moles de gaz à l'intérieur de celle-ci. Pour le matériau caractérisé dans cet exemple, avec un cycle de température adapté, on voit qu'il est possible d'obtenir une pression égale à environ 0,7 atm.

Ainsi, la pression pouvant être obtenue dans la cavité sera fonction des caractéristiques du cycle thermique réalisé, de la dose de gaz piégée ou implantée dans le matériau, de la surface du matériau comportant les espèces gazeuses ainsi que du volume de la cavité.

Dans une autre variante, les portions 110 peuvent être composées d'un métal, par exemple de l'indium, ou un alliage métallique tel que de l'AuSn.

Comme dans l'exemple précédemment décrit, des espèces gazeuses sont piégées dans ces portions métalliques lors du dépôt, par exemple PVD ou PECVD, de ces portions. Un tel dépôt PVD est réalisé en utilisant pour le plasma un gaz ou un mélange de gaz non soluble dans le métal. On peut par exemple réalisé un dépôt PVD d'aluminium avec un plasma d'argon ou de krypton, ou un dépôt d'or avec un plasma d'argon, de krypton ou d'azote ou un mélange de ces gaz.

Les portions 110 peuvent également être composées d'un alliage eutectique qui va permettre d'effectuer un dégazage à une température compatible avec les composants électroniques. On peut ainsi déposer une première couche métallique, par exemple composée d'or ou de nickel, par PVD en présence d'argon, de krypton ou d'azote ou encore un mélange de ces gaz et ensuite déposer une couche d'un autre métal par électrolyse, par exemple de l'étain. Dans le cas d'un dépôt d'or par PVD suivi d'un dépôt d'étain par électrolyse, en respectant les proportions correspondant à l'eutectique AuSn 80/20 en masse, un traitement thermique permettra la fusion de cet alliage à environ 280°C et donc la libération du ou des gaz piégés dans l'or à cette température. Selon un autre exemple, il est possible de déposer le premier métal (par exemple de l'or) suivant le même procédé PVD, mais en déposant le second métal (ici l'étain) avec un procédé d'électrolyse dégradé entraînant un piégeage de molécules de gaz $H_2$ dans l'étain. Cette électrolyse dégradée est réalisée en augmentant les densités de courants lors de l'électrolyse, augmentant ainsi la vitesse de dépôt du métal par rapport à une électrolyse classique, ce qui entraîne un piégeage de molécules d'hydrogène dans le matériau déposé par électrolyse. Le traitement thermique avec refonte va permettre la libération d'un mélange de gaz de type $ArH_2$ aux propriétés réductrices qui peuvent être favorables à la fiabilité du dispositif électronique 104, empêchant par exemple une oxydation de parties métalliques telles que des contacts électriques du dispositif.

Après avoir fermé hermétiquement la cavité 102, on expose (localement ou non) ces portions métalliques 110 à une température supérieure à la température de fusion du métal ou de l'alliage métallique des portions 110, entraînant ainsi sa fusion ainsi que le dégazage dans la cavité 102 des espèces gazeuses stockées dans ces portions 110. Cette variante a notamment pour avantage de libérer rapidement tout le gaz piégé dans les portions 110.

Dans une autre variante, les portions 110 peuvent correspondre à un bicouche métal / oxyde. Les portions 110 peuvent être formées par exemple par une couche d'aluminium déposée sur une couche de $SiO_2$ obtenue par un dépôt de type HDP (réalisée par plasma à haute densité, par exemple HDP-CVD) et mise en forme par un procédé de gravure sèche. Dans ce cas la couche d'aluminium et la couche de $SiO_2$ sont en liaison avec la cavité 102 (aucun matériau, notamment aucun matériau de passivation, n'est disposé sur les portions 110).

Dans l'exemple précédemment décrit, du gaz est libéré depuis les portions 110 dans la cavité 102 grâce au fait que le matériau des portions 110 est chargé en espèces gazeuses lors du dépôt PVD ou PECVD de ces portions 110. Dans une variante, il est possible que le gaz libéré dans la cavité provienne de dopants implantés dans les portions 110, ces dopants se libérant sous forme gazeuse lorsque les portions 110 sont chauffées. Ainsi, il est possible de réaliser les portions 110 à partir de techniques de réalisation autres qu'un dépôt PVD ou PECVD. De plus, lorsque le substrat 106 comporte le dispositif 104 par exemple de type MEMS ainsi que des dispositifs CMOS, les étapes ou les équipements d'implantation utilisés pour le dopage des dispositifs CMOS peuvent être utilisés pour réaliser le dopage des portions 110.

Les gaz libérés peuvent provenir à la fois des espèces gazeuses stockées dans les portions 110 lors du dépôt de celles-ci, et également de dopants implantés dans les portions 110.

La figure 4 représente une structure d'encapsulation 200 obtenue par la mise en oeuvre d'un procédé de réalisation selon un deuxième mode de réalisation.

Par rapport à la structure d'encapsulation 100 précédemment décrite, la structure d'encapsulation 200 ne comporte pas, sur le substrat 106, les portions de matériau 110 à partir desquelles s'échappent des espèces gazeuses. Dans ce deuxième mode de réalisation, les espèces gazeuses sont stockées dans une couche de matériau 202 recouvrant en partie ou totalement (comme c'est le cas sur l'exemple de la figure 4) les parois (paroi supérieure et parois latérales) du capot 114 se trouvant à l'intérieur de la cavité 102.

Une telle structure d'encapsulation 200 est par exemple obtenue en réalisant tout d'abord le dispositif électronique 104 sur le substrat 106, puis la couche sacrificielle 112. Une couche 202 de matériau chargé en éléments gazeux, par exemple de nature similaire au matériau des portions 110, est ensuite déposée de manière conforme (avec une épaisseur sensiblement constante), par exemple par un dépôt PVD ou PECVD, telle qu'elle recouvre la couche sacrificielle 112. Le procédé est ensuite achevé de manière analogue à celui mis en oeuvre pour réaliser la structure d'encapsulation 100, c'est-à-dire en réalisant le capot 114 ainsi que les trous de libération 116 (qui traversent également la couche 202), puis en gravant la couche sacrificielle 112 et le matériau sacrificiel 108, en bouchant les trous de libération 116 par le matériau de bouchage 118 et enfin en chauffant la couche 202 afin que les espèces gazeuses stockées dans la couche 202 soient libérées dans la cavité 102.

Le premier et le deuxième mode de réalisation précédemment décrits peuvent être combinés tels qu'une structure d'encapsulation 250 ainsi obtenue comporte, dans la cavité 102 fermée hermétiquement, les portions 110 et la couche 202 (voir figure 5).

De manière générale, le matériau dans lequel sont stockées les espèces gazeuses peut être réalisé sous n'importe quelle forme (portions, couches, etc.) et/ou selon n'importe quel motif, du moment que lors de la fermeture de la cavité, ce matériau soit disposé dans la cavité ou communique avec l'intérieur de celle-ci. Ainsi, il est possible que le matériau dans lequel sont stockées les espèces gazeuses soit réalisé dans un espace extérieur à la cavité 102 mais communiquant avec l'intérieur de celle-ci lorsqu'elle est fermée hermétiquement.

En variante des modes de réalisation précédemment décrits, les portions 110 et/ou la couche 202 peuvent être formées chacune par une superposition de plusieurs matériaux dont au moins un est chargé en espèces gazeuses, ces matériaux pouvant être différents les uns des autres. Une telle variante est avantageusement mise en oeuvre en réalisant des superpositions de matériaux métalliques. Ainsi, il est possible d'adapter la température de fusion du ou des matériaux enfermant les espèces gazeuses grâce aux eutectiques formés par ces différents matériaux métalliques.

Dans une autre variante, il est possible que le ou les matériaux des portions 110 et/ou de la couche 102 dans lesquels sont stockées les espèces gazeuses soient thermo-dégradables. Ces matériaux thermo-dégradables correspondent par exemple à des matériaux organiques tels que des polymères. Ainsi, en exposant ce matériau à une température supérieure ou égale à sa température à partir de laquelle il se dégrade, sa dégradation entraine le relâchement des espèces gazeuses dans la cavité 102. Après avoir libéré les espèces gazeuses par chauffage, le ou les matériaux restants peuvent être dégradés en partie ou totalement.

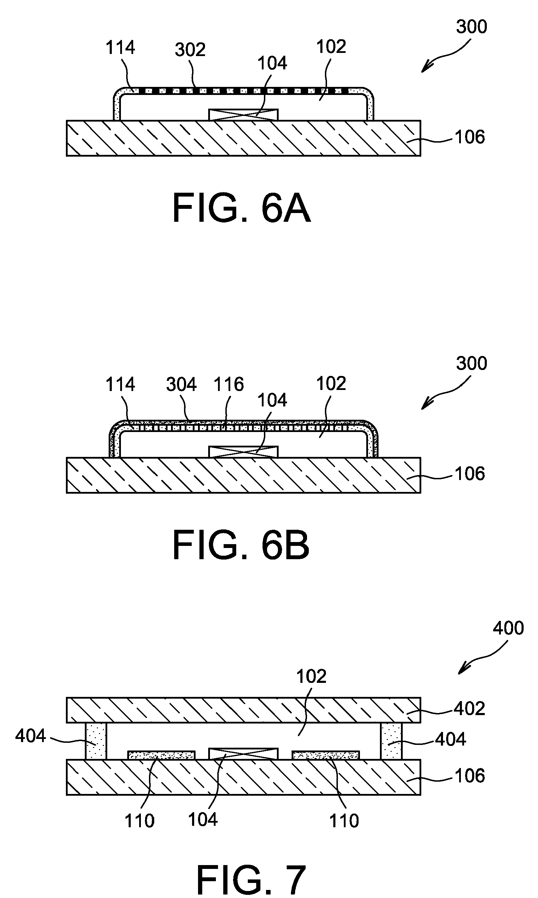

Les figures 6A et 6B représentent des structures d'encapsulation 300 obtenues par la mise en oeuvre d'un procédé de réalisation selon deux variantes d'un troisième mode de réalisation.

Par rapport à la structure d'encapsulation 100 précédemment décrite, la structure d'encapsulation 200 ne comporte pas les portions de matériau 110 à partir desquelles s'échappent des espèces gazeuses.

Dans ce troisième mode de réalisation, les espèces gazeuses sont stockées dans le matériau de bouchage utilisé pour boucher les trous de libérations 116, réalisé sous la forme de portions 302 (ou bouchons) obstruant chacune un ou plusieurs des trous de libération 116 (cas représenté sur la figure 6A) ou sous la forme d'une couche de matériau 304 recouvrant le capot 114 et donc également les trous de libération 116 (cas représenté sur la figure 6B).

Une telle structure d'encapsulation 300 est par exemple obtenue en réalisant tout d'abord le dispositif électronique 104 sur le substrat 106, puis la couche sacrificielle 112. Le capot 114 est réalisé sur la couche sacrificielle 112 et les trous de libération 116 sont réalisés à travers le capot 114. La couche sacrificielle 112 et le matériau sacrificiel 108 sont ensuite gravés. Les portions 302 ou la couche 304 de bouchage des trous de libération 116 sont ensuite réalisées par exemple par dépôt PVD ou PECVD, chargeant ainsi ces matériaux en éléments gazeux. Cette fermeture de la cavité 102 par les portions 302 ou la couche 304 est avantageusement réalisée sous vide ou sous pression réduite d'un ou plusieurs gaz non précurseurs. Le procédé est ensuite achevé de manière analogue aux précédents modes de réalisation, en chauffant (localement ou non) les portions 302 ou la couche 304 afin que les espèces gazeuses stockées dans les portions 302 ou la couche 304 soient libérées en partie dans la cavité 102.

Le troisième mode de réalisation peut être combiné avec le premier et/ou le deuxième mode de réalisation précédemment décrit afin que les portions 302 ou la couche 304 communiquent avec l'intérieur de la cavité 102 dans laquelle sont également disposées les portions 110 et/ou la couche 202. Les différentes variantes précédemment décrites en liaison avec le premier ou le deuxième mode de réalisation peuvent également s'appliquer à ce troisième mode de réalisation.

Dans tous les modes de réalisation précédemment décrits, les structures d'encapsulation sont obtenues par la mise en oeuvre de procédé de type PCM (Packaging Couche Mince). Toutefois, il est possible de réaliser ces différentes structures d'encapsulation par report de substrat. Dans ce cas, la couche capot 114 est remplacée par un deuxième substrat formant le capot de la cavité 102, les parois latérales de la cavité 102 étant formées par des portions de matériau formant une interface de collage entre le substrat 106 et le deuxième substrat. Une telle structure d'encapsulation 400 est représentée sur la figure 7. Dans cet exemple, la cavité 102 est formée entre le premier substrat 106 et un deuxième substrat 402 solidarité au premier substrat 106 via des portions de matériau 404 formant également les parois latérales de la cavité 102. Il est également possible que la cavité 102 soit formée dans le deuxième substrat 402, par exemple par micro-usinage, le premier substrat 106 et le deuxième substrat 402 pouvant dans ce cas être solidarisés directement l'un à l'autre. En variante, le matériau dans lequel sont enfermées les espèces gazeuses peut être réalisé sous la forme de portions et/ou de couche disposées par exemple contre le deuxième substrat 402 et/ou les parois latérales 404 de la cavité 102. Les différentes variantes précédemment décrites peuvent aussi s'appliquer à la structure d'encapsulation 400.

## Revendications

1. Procédé de réalisation d'une structure d'encapsulation (100, 200, 250, 300, 400) pour au moins un dispositif électronique comportant au moins les étapes de :

   - réalisation d'au moins une portion de matériau (110, 202, 302, 304) apte à libérer au moins un gaz lorsque ledit matériau est chauffé, la portion de matériau (110, 202, 302, 304) communiquant avec l'intérieur d'une cavité (102) fermée hermétiquement de la structure d'encapsulation (100, 200, 250, 300, 400),
   - chauffage de tout ou partie de ladite portion de matériau (110, 202, 302, 304) tel qu'au moins une partie du gaz soit libérée depuis ladite portion de matériau (110, 202, 302, 304) dans la cavité (102),

   et dans lequel ladite portion de matériau (110, 202, 302, 304) apte à libérer au moins un gaz lorsque ledit matériau est chauffé comporte des éléments piégés dans ladite portion de matériau (110, 202, 302, 304), lesdits éléments piégés se libérant de ladite portion de matériau (110, 202, 302, 304) sous forme gazeuse lors du chauffage dudit matériau sans décomposition de ladite portion de matériau (110, 202, 302, 304), ce gaz augmentant la pression régnant dans la cavité, ce qui permet d'obtenir une pression finale dans la cavité fermée hermétiquement qui est supérieure à la pression régnant dans la cavité lors de sa fermeture, tout en évitant d'avoir à réaliser une implantation gazeuse dans la cavité après sa fermeture.

2. Procédé selon la revendication 1, comportant en outre, avant une fermeture hermétique de la cavité (102), une étape de réalisation d'au moins un dispositif électronique (104) dans la cavité (102).

**3.** Procédé selon la revendication 2, comportant en outre, avant la mise en oeuvre de l'étape de chauffage de ladite portion de matériau (110), les étapes de :

- réalisation du dispositif électronique (104) et de ladite portion de matériau (110) sur un substrat (106),
- réalisation de la cavité (102) fermée hermétiquement dans laquelle sont disposés au moins le dispositif électronique (104) et ladite portion de matériau (110), la cavité (102) étant formée entre le substrat (106) et un capot (114).

**4.** Procédé selon la revendication 3, comportant en outre, lors de la réalisation de la cavité (102) fermée hermétiquement, la réalisation d'au moins une couche de matériau (202) apte à libérer au moins un gaz lorsque ledit matériau est chauffé, disposée dans la cavité (102) et contre le capot (114), ou formant le capot (114), et dans lequel l'étape de chauffage réalise également le chauffage de ladite couche de matériau (202), libérant au moins une partie du gaz depuis ladite couche de matériau (202) dans la cavité (102).

**5.** Procédé selon la revendication 2, comportant en outre, avant la mise en oeuvre de l'étape de chauffage de ladite portion de matériau (202), les étapes de :

- réalisation du dispositif électronique (104) sur un substrat (106),
- réalisation de la cavité (102) fermée hermétiquement dans laquelle est disposé au moins le dispositif électronique (104), la cavité (102) étant formée entre le substrat (106) et un capot (114), ladite portion de matériau (202) formant une couche de matériau disposée dans la cavité (102) et contre le capot (114).

**6.** Procédé selon l'une des revendications 3 à 5, dans lequel la réalisation de la cavité (102) comporte la réalisation d'au moins un trou (116) à travers au moins le capot (114) tel que le trou (116) forme un accès à l'intérieur de la cavité (102), la cavité (102) étant ensuite fermée hermétiquement en bouchant le trou (116) par au moins une deuxième portion de matériau (302) apte à libérer au moins un gaz lorsque ledit matériau est chauffé, et dans lequel l'étape de chauffage réalise également le chauffage de ladite deuxième portion de matériau (302), libérant au moins une partie du gaz depuis ladite deuxième portion de matériau dans la cavité (102).

**7.** Procédé selon l'une des revendications 3 à 5, dans lequel la réalisation de la cavité (102) comporte la réalisation d'au moins un trou (116) à travers au moins le capot (114) tel que le trou (116) forme un accès à l'intérieur de la cavité (102), la cavité (102) étant ensuite fermée hermétiquement en bouchant le trou (116) par au moins une couche de matériau (304) apte à libérer au moins un gaz lorsque ledit matériau est chauffé et recouvrant le capot (114), et dans lequel l'étape de chauffage réalise également le chauffage de ladite couche de matériau (304), libérant au moins une partie du gaz depuis ladite couche de matériau (304) dans la cavité (102).

**8.** Procédé selon la revendication 2, comportant en outre, avant la mise en oeuvre de l'étape de réalisation de ladite portion de matériau (302), les étapes de :

- réalisation du dispositif électronique (104) sur un substrat (106),
- réalisation de la cavité (102) dans laquelle est disposé au moins le dispositif électronique (104), la cavité (102) étant formée entre le substrat (106) et un capot (114),

et dans lequel la réalisation de la cavité (102) comporte la réalisation d'au moins un trou (116) à travers au moins le capot (114), la cavité (102) étant ensuite fermée hermétiquement en réalisant ladite portion de matériau (302) telle qu'elle bouche le trou (116).

**9.** Procédé selon la revendication 2, comportant en outre, avant la mise en oeuvre de l'étape de réalisation de ladite portion de matériau (304), les étapes de :

- réalisation du dispositif électronique (104) sur un substrat (106),
- réalisation de la cavité (102) dans laquelle est disposé au moins le dispositif électronique (104), la cavité (102) étant formée entre le substrat (106) et un capot (114),

et dans lequel la réalisation de la cavité (102) comporte la réalisation d'au moins un trou (116) à travers au moins le capot (114), la cavité (102) étant ensuite fermée hermétiquement en réalisant ladite portion de matériau (304) sous la forme d'une couche recouvrant le capot (114).

**10.** Procédé selon l'une des revendications précédentes, dans lequel au moins ladite portion de matériau (110, 202, 302, 304) est réalisée par au moins un dépôt de type PVD ou PECVD dudit matériau, ledit dépôt réalisant un stockage d'éléments gazeux dans ledit matériau correspondant à au moins une partie des éléments piégés dans ladite portion de matériau.

**11.** Procédé selon l'une des revendications précédentes, dans lequel les éléments piégés dans ladite portion de matériau comportent des dopants implantés dans ledit matériau, lesdits dopants se libérant sous forme gazeuse lors du chauffage dudit matériau.

**12.** Procédé selon l'une des revendications précédentes, dans lequel une fermeture hermétique de la cavité (102) est réalisée sous vide ou sous pression réduite d'au moins un gaz.

**13.** Procédé selon l'une des revendications précédentes, dans lequel ledit matériau apte à libérer au moins un gaz lorsque ledit matériau est chauffé est composé d'au moins un métal, le chauffage de ladite portion de matériau (110, 202, 302, 304) étant réalisé à une température supérieure ou égale à la température de fusion dudit matériau.

**14.** Procédé selon l'une des revendications précédentes, dans lequel la réalisation de ladite portion de matériau (110, 202, 302, 304) apte à libérer au moins un gaz lorsque ledit matériau est chauffé comporte un premier dépôt de type PVD ou PECVD d'un premier métal et un deuxième dépôt par électrolyse ou électrolyse dégradée d'un deuxième métal sur le premier métal.


**Patentansprüche**

**1.** Verfahren zum Herstellen einer Verkapselungsstruktur (100, 200, 250, 300, 400) für wenigstens eine elektronische Vorrichtung, umfassend wenigstens die Schritte:

- Herstellen wenigstens einen Abschnitts aus Material (110, 202, 302, 304), welches in der Lage ist, wenigstens ein Gas freizusetzen, wenn das Material erwärmt wird, wobei der Abschnitt aus Material (110, 202, 302, 304) mit dem Inneren eines hermetisch abgeschlossenen Hohlraums (102) der Verkapselungsstruktur (100, 200, 250, 300, 400) in Verbindung steht,
- Erwärmen des ganzen oder eines Teils des Abschnitts aus Material (110, 202, 302, 304), so dass wenigstens ein Teil des Gases aus dem Abschnitt aus Material (110, 202, 302, 304) in den Hohlraum (102) freigesetzt wird,

und wobei der Abschnitt aus Material (110, 202, 302, 304), welcher in der Lage ist, wenigstens ein Gas freizusetzen, wenn das Material erwärmt wird, verborgene Elemente in dem Abschnitt aus Material (110, 202, 302, 304) umfasst, welche verborgenen Elemente sich aus dem Abschnitt aus Material (110, 202, 302, 304) in gasförmiger Form bei Erwärmen des Materials ohne Zersetzung des Abschnitts aus Material (110, 202, 302, 304) freisetzen, wobei dieses Gas den in dem Hohlraum herrschenden Druck erhöht, was es erlaubt, einen finalen Druck in dem hermetisch abgeschlossenen Hohlraum zu erhalten, welcher größer ist als der in dem Hohlraum vor dessen Verschließen herrschende Druck, wodurch verhindert wird, dass eine gasförmige Zufuhr in den Hohlraum nach dessen Verschließen vorgenommen werden muss.

**2.** Verfahren nach Anspruch 1, ferner umfassend vor einem hermetischen Verschließen des Hohlraums (102) einen Schritt eines Herstellens wenigstens einer elektronischen Vorrichtung (104) in dem Hohlraum (102).

**3.** Verfahren nach Anspruch 2, ferner umfassend vor dem Ausführen des Schritts des Erwärmens des Abschnitts aus Material (110), die Schritte:

- Herstellen der elektronischen Vorrichtung und des Abschnitts aus Material (110) auf einem Substrat (106),
- Herstellen des hermetisch abgeschlossenen Hohlraums (102), in welchem wenigstens die elektronische Vorrichtung (104) und der Abschnitt aus Material (110) angeordnet sind, wobei der Hohlraum (102) zwischen dem Substrat (106) und einer Haube (114) gebildet ist.

**4.** Verfahren nach Anspruch 3, ferner umfassend während des Herstellens des hermetisch abgeschlossenen Hohlraums (102) das Herstellen von wenigstens einer Schicht aus Material (202), welche in der Lage ist, wenigstens ein Gas freizugeben, wenn das Material erwärmt wird, angeordnet in dem Hohlraum (102) und gegen die Haube (114) oder die Haube (114) bildend, und wobei der Schritt des Erwärmens ebenfalls das Erwärmen der Schicht aus Material (202) ausführt, wobei wenigstens ein Teil des Gases aus der Schicht aus Material (202) in den Hohlraum (102) freigesetzt wird.

5. Verfahren nach Anspruch 2, ferner umfassend vor dem Ausführen des Schritts des Erwärmens des Abschnitts aus Material (202), die Schritte:

- Herstellen der elektronischen Vorrichtung (104) auf einem Substrat (106),
- Herstellen des hermetisch abgeschlossenen Hohlraums (102), in welchem wenigstens die elektronische Vorrichtung (104) angeordnet ist, wobei der Hohlraum (102) zwischen dem Substrat (106) und einer Haube (114) eingeschlossen ist, wobei der Abschnitt aus Material (202) eine Schicht aus Material bildet, welche in dem Hohlraum (102) und gegen die Haube (114) angeordnet ist.

6. Verfahren nach einem der Ansprüche 3 bis 5, wobei das Herstellen des Hohlraums (102) das Herstellen wenigstens eines Lochs (116) durch wenigstens die Haube (114) derart umfasst, dass das Loch (116) einen Zugang zum Inneren des Hohlraums (102) bildet, wobei der Hohlraum (102) anschließend hermetisch abgeschlossen wird, indem das Loch (116) durch wenigstens einen zweiten Abschnitt aus Material (302) verschlossen wird, welcher in der Lage ist, wenigstens ein Gas freizusetzen, wenn das Material erwärmt wird, und wobei der Schritt des Erwärmens ebenfalls das Erwärmen des zweiten Abschnitts aus Material (302) ausführt, wobei wenigstens ein Teil des Gases aus dem zweiten Abschnitt aus Material in den Hohlraum (102) freigesetzt wird.

7. Verfahren nach einem der Ansprüche 3 bis 5, wobei das Herstellen des Hohlraums (102) das Herstellen wenigstens eines Lochs (116) durch wenigstens die Haube (114) derart umfasst, dass das Loch (116) einen Zugang zum Inneren des Hohlraums (102) bildet, wobei der Hohlraum (102) anschließend hermetisch abgeschlossen wird, indem das Loch (116) durch wenigstens eine Schicht aus Material (304) verschlossen wird, welche in der Lage ist, wenigstens ein Gas freizusetzen, wenn das Material erwärmt wird, und welche die Haube (114) bedeckt, und wobei der Schritt des Erwärmens ebenfalls das Erwärmen der Schicht aus Material (304) ausführt, wobei wenigstens ein Teil des Gases aus der Schicht aus Material (304) in den Hohlraum (102) freigesetzt wird.

8. Verfahren nach Anspruch 2, ferner umfassend vor dem Ausführen des Schritts des Herstellens des Abschnitts aus Material (302), die Schritte:

- Herstellen der elektronischen Vorrichtung (104) auf einem Substrat (106),
- Herstellen des Hohlraums (102), in welchem wenigstens die elektronische Vorrichtung (104) angeordnet ist, wobei der Hohlraum (102) zwischen dem Substrat (106) und einer Haube (114) gebildet ist, und wobei das Herstellen des Hohlraums (102) das Herstellen von wenigstens einem Loch (116) durch wenigstens die Haube (114) umfasst, wobei der Hohlraum (102) anschließend hermetisch abgeschlossen wird, indem der Abschnitt aus Material (302) derart hergestellt wird, dass er das Loch (116) verschließt.

9. Verfahren nach Anspruch 2, ferner umfassend vor dem Ausführen des Schritts des Herstellens des Abschnitts aus Material (304) die folgenden Schritte:

- Herstellen der elektronischen Vorrichtung (104) auf einem Substrat (106),
- Herstellen des Hohlraums (102), in welchem wenigstens die elektronische Vorrichtung (104) angeordnet ist, wobei der Hohlraum (102) zwischen dem Substrat (106) und einer Haube (114) gebildet wird,

und wobei das Herstellen des Hohlraums (102) das Herstellen wenigstens eines Lochs (116) durch wenigstens die Haube (114) umfasst, wobei der Hohlraum (102) anschließend hermetisch abgeschlossen wird, indem der Abschnitt aus Material (304) in Form einer die Haube (114) bedeckenden Schicht hergestellt wird.

10. Verfahren nach einem der vorhergehenden Ansprüche, wobei wenigstens der Abschnitt aus Material (110, 202, 302, 304) durch wenigstens ein Ablagern vom Typ PVD oder PECVD des Materials hergestellt wird, welches Ablagern einen Vorrat an gasförmigen Elementen in dem Material herstellt, welches wenigstens einem Teil der verborgenen Elemente in dem Abschnitt aus Material entspricht.

11. Verfahren nach einem der vorhergehenden Ansprüche, wobei die verborgenen Elemente in dem Abschnitt aus Material in das Material implantierte Dotierungsstoffe umfassen, welche Dotierungsstoffe sich in gasförmiger Form freisetzen, wenn das Material erwärmt wird.

12. Verfahren nach einem der vorhergehenden Ansprüche, wobei ein hermetisches Abschließen des Hohlraums (102) im Vakuum oder unter verringertem Druck von wenigstens einem Gas hergestellt wird.

13. Verfahren nach einem der vorhergehenden Ansprüche, wobei das Material, welches in der Lage ist, wenigstens ein Gas freizusetzen, wenn das Material erwärmt wird, aus wenigstens einem Metall zusammengesetzt ist, wobei das Erwärmen des Abschnitts aus Material (110, 202, 302, 304) bei einer Temperatur durchgeführt wird, welche größer oder gleich der Fusionstemperatur des Materials ist.

14. Verfahren nach einem der vorhergehenden Ansprüche, wobei das Herstellen des Abschnitts aus Material (110, 202, 302, 304), welches in der Lage ist, wenigstens ein Gas freizusetzen, wenn das Material erwärmt wird, ein erstes Ablagern vom Typ PVD oder PEVCD eines ersten Metalls und ein zweites Ablagern durch Elektrolyse oder Abtragungselektrolyse eines zweites Metalls auf dem ersten Metall umfasst.

**Claims**

1. Process for making an encapsulation structure (100, 200, 250, 300, 400) for at least one electronic device, comprising at least the following steps:

   - make at least one portion of material (110, 202, 302, 304) capable of releasing at least one gas when said material is heated, the portion of material (110, 202, 302, 304) communicating with the inside of a hermetically closed cavity (102) of the encapsulation structure (100, 200, 250, 300, 400),
   - heat all or part of said portion of material (110, 202, 302, 304) such that at least part of the gas is released from said portion of material (110, 202, 302, 304) in the cavity (102),

   and in which said portion of material (110, 202, 302, 304) capable of releasing at least one gas when said material is heated comprises elements trapped in said portion of material (110, 202, 302, 304), said trapped elements being released from said portion of material (110, 202, 302, 304) in gaseous form when said material is heated without decomposition of said portion of material (110, 202, 302, 304), this gas increasing the pressure in the cavity, so that a final pressure can be obtained in the hermetically closed cavity that is greater than the pressure in the cavity when it was closed, without the need for a gas implantation in the cavity after it has been closed.

2. Process according to claim 1, also comprising, a step to make at least one electronic device (104) in the cavity (102) before the cavity (102) is hermetically closed.

3. Process according to claim 2, also comprising the following steps before application of the heating step of said portion of material (110):

   - make the electronic device (104) and said portion of material (110) on a substrate (106),
   - make the hermetically closed cavity (102) in which at least the electronic device (104) and said portion of material (110) are placed, the cavity (102) being formed between the substrate (106) and a cover (114).

4. Process according to claim 3, also comprising the production of at least one layer of material (202) capable of releasing at least one gas when said material is heated, arranged in the cavity (102) and in contact with the cover (114), or forming the cover (114), during the making of the hermetically closed cavity (102), and in which the heating step also heats said layer of material (202), releasing at least part of the gas from said material layer (202) in the cavity (102).

5. Process according to claim 2, also comprising the following steps before the heating step is applied to said portion of material (202):

   - make the electronic device (104) on a substrate (106),
   - make the hermetically closed cavity (102) in which at least the electronic device (104) is placed, the cavity (102) being formed between the substrate (106) and a cover (114), said portion of material (202) forming a layer of material arranged in the cavity (102) and in contact with the cover (114).

6. Process according to one of claims 3 to 5, in which production of the cavity (102) includes production of at least one hole (116) through at least the cover (114) such that the hole (116) forms an access inside the cavity (102), the cavity (102) then being hermetically closed by plugging the hole (116) with at least one second portion of the material (302) capable of releasing at least one gas when said material is heated, and in which the heating step also heats said second portion of material (302), releasing at least part of the gas from said second portion of material in the cavity (102).

7. Process according to one of claims 3 to 5, in which production of the cavity (102) includes production of at least one hole (116) through at least the cover (114) such that the hole (116) forms an access inside the cavity (102), the cavity (102) then being hermetically closed by plugging the hole (116) with at least one layer of material (304) capable of releasing at least one gas when said material is heated and covering the cover (114), and in which the heating step also heats said material layer (304), releasing at least part of the gas from said layer of material (304) in the cavity (102).

8. Process according to claim 2, also comprising the following steps before the step to make said portion of material (302):

   - make the electronic device (104) on a substrate (106),
   - make the cavity (102) in which at least the electronic device (104) is placed, the cavity (102) being formed between the substrate (106) and a cover (114),

   and in which production of the cavity (102) includes production of at least one hole (116) through at least the cover (114), the cavity (102) then being hermetically closed by making said portion of material (302) such that it plugs the hole (116).

9. Process according to claim 2, also comprising the following steps before the step to make said portion of material (304):

   - make the electronic device (104) on a substrate (106),
   - make the cavity (102) in which at least the electronic device (104) is placed, the cavity (102) being formed between the substrate (106) and a cover (114),

   and in which production of the cavity (102) includes the production of at least one hole (116) through at least the cover (114), the cavity (102) then being hermetically closed by making said portion of material (304) in the form of a layer covering the cover (114).

10. Process according to one of the previous claims, in which at least said portion of material (110, 202, 302, 304) is made by at least PVD or PECVD type deposition of said material, said deposition storing gaseous elements in said material corresponding to at least part of elements trapped in said portion of material.

11. Process according to one of the previous claims, in which elements trapped in said portion of material comprise doping agents implanted in said material, said doping agents being released in gaseous form when said material is heated.

12. Process according to one of the previous claims, in which the cavity (102) is hermetically closed under a vacuum or at low pressure of at least one gas.

13. Process according to one of the previous claims, in which said material capable of releasing at least one gas when said material is heated is composed of at least one metal, heating of said portion of material (110, 202, 302, 304) being done at a temperature greater than or equal to the melting point of said material.

14. Process according to one of the previous claims, in which production of said portion of material (110, 202, 302, 304) capable of releasing at least one gas when said material is heated comprises a first PVD or PECVD type deposition of a first metal and a second deposition by electrolysis or degraded electrolysis of a second metal on the first metal.

FIG. 1A

FIG. 1B

FIG. 1C

FIG. 1D

FIG. 1E

FIG. 2

FIG. 3

FIG. 4

FIG. 5

FIG. 6A

FIG. 6B

FIG. 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0846941 A1

- DE 102007022509 A1